Europäisches Patentamt

European Patent Office

Office européen des brevets

(19)

(11) Veröffentlichungsnummer: **0 075 200**
**B1**

# EUROPÄISCHE PATENTSCHRIFT

(12)

(45) Veröffentlichungstag der Patentschrift:
**05.08.87**

(21) Anmeldenummer: **82108283.1**

(22) Anmeldetag: **09.09.82**

(51) Int. Cl.⁴: **H 01 L 23/42**

---

(54) **Leistungshalbleiterbauelement für Siedekühlung.**

---

(30) Priorität: **19.09.81 DE 3137407**

(43) Veröffentlichungstag der Anmeldung:
**30.03.83 Patentblatt 83/13**

(45) Bekanntmachung des Hinweises auf die Patenterteilung:
**05.08.87 Patentblatt 87/32**

(84) Benannte Vertragsstaaten:
**CH DE FR IT LI SE**

(56) Entgegenhaltungen:
**EP - A - 0 075 036**
**DE - A - 2 705 476**
**DE - A - 2 938 096**

(73) Patentinhaber: **BBC Aktiengesellschaft Brown, Boveri & Cie., Haselstrasse, CH-5401 Baden (CH)**

(72) Erfinder: **Klein, Erwin, Dresdener Strasse 5, D-6805 Heddesheim (DE)**

(74) Vertreter: **Kempe, Wolfgang, Dr., c/o BROWN, BOVERI & CIE AG ZPT Postfach 351, D-6800 Mannheim 31 (DE)**

EP 0 075 200 B1

## Beschreibung

Die Erfindung bezieht sich auf ein Leistungshalbleiterbauelement für Siedekühlung gemäss dem Oberbegriff des Anspruches 1.

Ein solches Leistungshalbleiterbauelement für Siedekühlung ist aus DE-A-29 38 096 bekannt. Dort dienen die Multikontakte ausschliesslich zur Stromführung und durchstossen die Gehäuseaussenwandung bzw. kontaktieren direkt die metallene Gehäuseinnenwandung. Ein im Gehäuse angeordneter Kühlkörper ist nicht vorgesehen, da die Halbleiterkristallscheibe direkt vom Kältemittel angeströmt wird. Die Multikontakte können stoffschlüssig oder elektrisch kontaktierend, z.B. als Spiralfedern, ausgeführt sein. Als Kältemittel sind sowohl Flüssigkeiten als auch Gase einsetzbar. Das Kältemittel muss isolierend sein. Als Kühlflüssigkeit können Öl oder inerte Flüssigkeiten mit möglichst hohem Siedepunkt Verwendung finden. Bei Ausnutzung der Siedekühlung, d.h. der Verdampfungswärme bei Aggregatzustandsänderung des Kältemittels vom flüssigen in den gasförmigen Zustand, tritt ein vorteilhafter Kühleffekt auf. Eine detaillierte Ausführungsform eines Leistungshalbleiterelementes speziell für die Siedekühlung wird jedoch nicht beschrieben.

Aus DE-A-28 55 493 ist ein weiteres Leistungshalbleiterbauelement mit Multikontakten bekannt. Dort bestehen die Multikontakte aus einem bürstenähnlichen Bündel von Einzeldrähten, wobei mindestens ein Teil der Einzeldrähte eine grössere Länge besitzt, als sie dem Abstand zwischen den beiden Scheibenoberflächen entspricht. Die Multikontakte sind stoffschlüssig mit der Halbleiterkristallscheibe und mit Wärmeableitscheiben verbunden. Das Gehäuse des Leistungshalbleiterbauelementes wird durch die Wärmeableitscheiben, eine Keramikhülse sowie abdeckende Metallringe gebildet. Eine Durchströmung des Gehäuses selbst mit einem Kältemittel ist nicht vorgesehen.

Aus DE-A-29 37 49 ist ein ähnliches Leistungshalbleiterbauelement bekannt, bei dem das die Multikontakte bildende Bündel aus einem zu einer Spirale aufgewickelten Metallband besteht, wobei das Band in regelmässigen Abständen derart mit Schlitzen versehen ist, dass eine Vielzahl von federnden Metallstegen entsteht, die einseitig durch ein nicht geschlitztes Stück des Metallbandes verbunden sind. Auch bei diesem Leistungshalbleiterbauelement ist nicht vorgesehen, das Gehäuse selbst mit einem Kältemittel zu durchströmen.

Der Erfindung liegt die Aufgabe zugrunde, bei einem Leistungshalbleiterbauelement für Siedekühlung der eingangs genannten Art eine detaillierte Ausführungsform eines elektrisch und kältemittelmässig anschlussfähigen Elementes anzugeben, wobei eine Scheibenzellenbauart ohne kraftschlüssige Kontaktierung vorliegen soll.

Diese Aufgabe wird durch die im Anspruch 1 gekennzeichneten Merkmale gelöst.

Die mit der Erfindung erzielbaren Vorteile bestehen insbesondere darin, dass das Leistungshalbleiterbauelement nicht kraftschlüssig kontaktiert werden muss (wichtig bei grossen Halbleiterkristallscheiben-Durchmessern), jedoch trotzdem sehr gut gekühlt werden kann. Es eignet sich insbesondere als Einzelbaustein eines aus vielen gleichartigen Leistungshalbleiterbauelementen aufgebauten Blocks, wobei die Zugänglichkeit zu den einzelnen Bauelementen sehr gut ist (wichtig für Austausch defekter Bausteine) und eine grosse Flexibilität bezüglich Einbau- bzw. Aufstellungsmöglichkeiten gegeben ist. Die Menge des Kältemittels kann wegen des kompakten Aufbaues des Bauelementes vorteilhaft gering sein, woraus entsprechende Gewichts- und Kosteneinsparungen resultieren.

Vorteilhafte Ausgestaltungen der Erfindung sind in den Unteransprüchen gekennzeichnet.

Die Erfindung wird nachstehend anhand des in den Zeichnungen dargestellten Ausführungsbeispieles erläutert.

Es zeigen:

Fig. 1 das Leistungshalbleiterbauelement für Siedekühlung in geschnittenem Aufriss,

Fig. 2 das Leistungshalbleiterbauelement in teils geschnittenem Grundriss,

Fig. 3 eine Gesamtanordnung von Leistungshalbleiterbauelementen mit Rückkühleinrichtung.

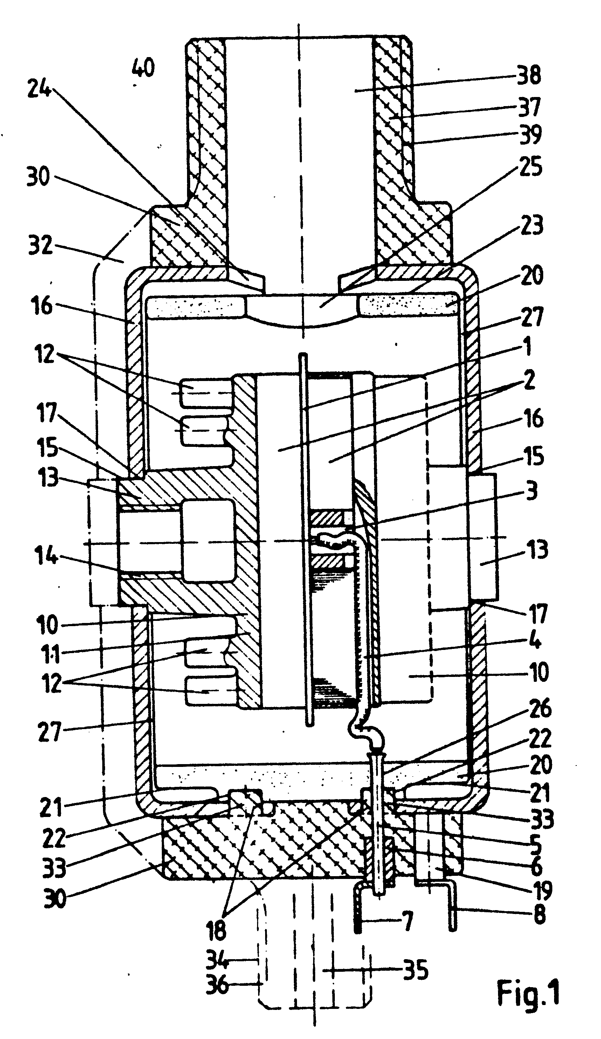

In Fig. 1 ist das Leistungshalbleiterbauelement für Siedekühlung geschnittenem Aufriss dargestellt. Eine im Inneren des Leistungshalbleiterbauelementes befindliche Halbleiterkristallscheibe 1 ist über Multikontakte 2 (Multifederkontakte) beidseitig mittels stoffschlüssiger Verbindungen (Lötung) mit Kühlkörpern 10 verbunden. Jeder der beiden Kühlkörper 10 besteht aus einem Boden 11, der zur Vergrösserung der Oberfläche Kühlzapfen 12 trägt. Für den elektrischen Anschluss des Halbleiterbauelements ist an jedem Kühlkörper 10 zentrisch ein Anschlussauge 13 mit Innengewinde 14 angeformt, wobei das Anschlussauge 13 aussen mit einer Andrehung 15 versehen ist. Auf jeder dieser Andrehungen 15 ist ein topfähnlicher metallener Deckel 16 über seine zentrale Bohrung 17 stoffschlüssig befestigt.

Bevor die einzelnen Bauteile Halbleiterkristallscheibe 1, Multikontakt 2, Kühlkörper 10 und Deckel 16 des Leistungshalbleiterbauelementes miteinander verbunden werden, wird zwischen die beiden Deckel 16 eine Keramikhülse 20 eingelegt. Diese Hülse 20 ist beidseitig mit äusseren Andrehungen 21, mehreren kleineren Grundbohrungen 22, einer Abflachung 23 und zwei grösseren Bohrungen 25 versehen (es ist lediglich eine Bohrung 25 dargestellt).

Diese so zusammengebaute Baugruppe wird mit einer Isolierhülse 30 (aus Isoliermasse) umpresst. Dabei dient die Keramikhülse 20 als verlorene Form. Diese Isolierhülse 30, die nötigenfalls mit beidseitig angebrachten Isolierdeckeln 32 (aus Isoliermasse) erweitert werden kann, schafft die notwendige äussere elektrische Isolation des Leistungshalbleiterbauelementes. Ausserdem stellt die Isolierhülse 30 die mechanische Verbindung zwischen den metallenen Deckel 16 her, so dass vorteilhaft eine Zugentlastung der stoffschlüssigen Verbindungsstellen vorliegt. Zu diesem Zweck sind die metallenen Deckel 16 mit Bohrungen 18 und die Keramikhülsen 20 mit den Grundbohrungen 22 versehen, in die sich die Isoliermasse der Isolierhülse 30 während des Pressvorganges mit Noppen 33 verankert. An der Isolierhülse 30 ist ein Stutzen 34 mit zentraler Bohrung 35 (für den Kältemittelzulauf) und Gewinde 36 sowie diametral gegenüberliegend ein Stutzen 37 mit Bohrung 38 (für den Kältemittelablauf) und Aussengewinde 39 angeformt. Diese Stutzen 34, 37 dienen wie oben erwähnt der Zu- bzw. Abfuhr von flüssigem bzw. gasförmigem Kältemittel, wobei die eingetragene Pfeilrichtung die Richtung des Kältemittelweges angibt. Damit das gasförmige Kältemittel ungehindert in die Bohrung 38 übertreten kann, sind die metallenen Deckel 16 mit teilkreisförmigen Ausschnitten 24 versehen.

Wird das Leistungshalbleiterbauelement geschilderter Bauart als Thyristor ausgebildet, dann wird eine Gate-Anschlussleitung 4 durch eine Bohrung 3 des Multikontaktes 2 zur Kontaktierung mit der Halbleiterkristallscheibe 1 geführt. Der externe Gate-Anschluss erfolgt mittels eines Anschlussstiftes 5, welcher in einer Bohrung 26 der Keramikhülse 20 fixiert ist. Der Anschlussstift 5 ist mittels einer Büchse 6 in der Isolierhülse 30 verankert. Am äusseren Ende des Anschlussstiftes 5 ist ein Flachstecker 7 befestigt. Ein Hilfs-Kathodenanschluss des Thyristors erfolgt über einen metallenen Bolzen 19, der am kathodenseitigen metallenen Deckel 16 des Halbleiterbauelementes angeschweisst ist und einen externen Flachstecker 8 trägt.

Bei entsprechender räumlicher Zuordnung des Leistungshalbleiterbauelementes zur Rückkühleinrichtung und ausreichender Dimensionierung der Gasleitung sowie der Bohrung 38 für Kältemittelablauf kann durch Schwerkraft die Kältemittelrückführung über die Gasleitung selbst geschehen, es wird bei diesem Sonderfall also nur ein Stutzen 37 mit einer Bohrung 38 für Zu- und Ablauf des Kältemittels benötigt. Das flüssige Kältemittel legt sich dann vornehmlich an die Wandung der Bohrung 38 an. Beim Abtropfen von dieser trifft es auf die Abflachung 23 der Keramikhülse 20 und läuft dann an den Andrehungen 21 weiter, um durch die zwischen Deckel 16 und Keramikhülse 20 bestehende Spalte 27 in den Verdampfungsraum im Innern der Keramikhülse 20 überzutreten. Das gesamte, in Fig. 1 beschriebene Leistungshalbleiterbauelement für Siedekühlung ist mit Bezugszeichen 40 gekennzeichnet.

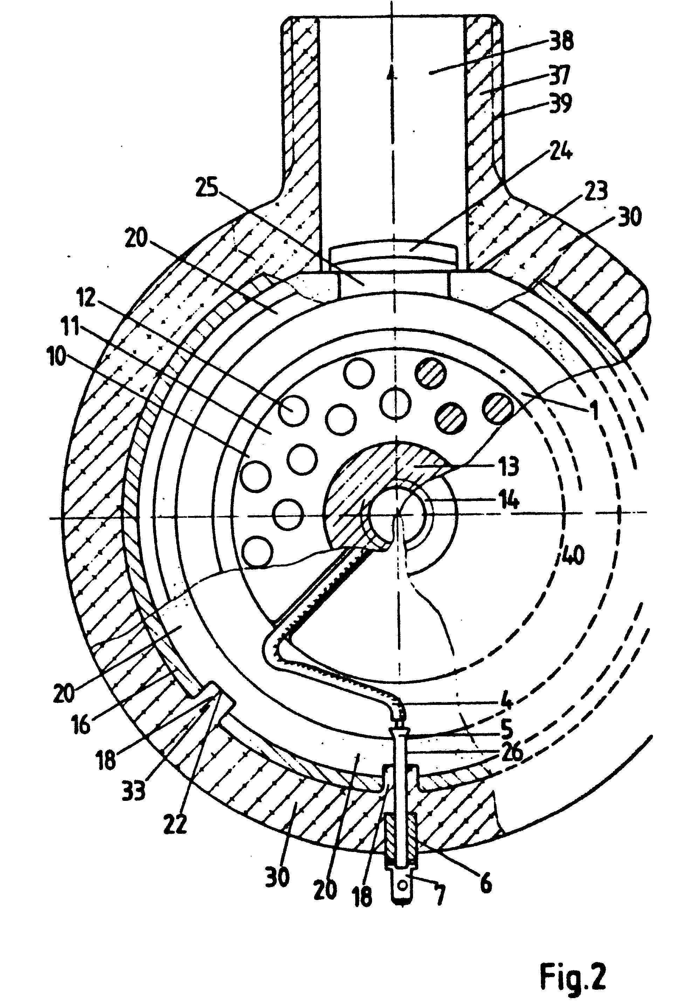

In Fig. 2 ist das Leistungshalbleiterbauelement 40 in teil geschnittenem Grundriss dargestellt. Im einzelnen ist hieraus der radiale Aufbau des Elementes mit zentraler Halbleiterkristallscheibe 1, sich darauf befindendem Kühlkörper 10 (mit Boden 11 und Kühlzapfen 12), mit sich nach aussen zu anschliessender Keramikhülse 20, metallenem Deckel 16 und Isolierhülse 30 ersichtlich.

Zu erkennen sind ferner die Verankerungen zwischen Keramikhülse 20 und Isolierhülse 30 mittels der Noppen 33, die durch die Bohrungen 18 der metallenen Deckeln 16 in die Grundbohrungen 22 der Keramikhülse 20 eingreifen. Desweiteren ist der Gate-Anschluss über den mittels der Büchse 6 in der Isolierhülse 30 verankerten, sowie durch eine Bohrung 18 im metallenen Deckel 16 und die Bohrung 26 durch die Keramikhülse 20 geführten Anschlussstift 5 ersichtlich, wobei der Anschlussstift 5 extern mit dem Flachstecker 7 und intern mit der Gate-Anschlussleitung 4 verbunden ist.

In Fig. 2 sind ferner das Anschlussauge 13 mit Innengewinde 14 zum elektrischen Anschluss des Leistungshalbleiterelementes sowie der Kältemittelablauf über den Stutzen 37 mit Aussengewinde 39 der Isolierhülse 30 dargestellt. Der Kältemittelablauf (siehe Pfeilrichtung) erfolgt über die Bohrung 25 in der Keramikhülse 20 am Ort der Abflachung 23, weiter über den teilkreisförmigen Ausschnitt 24 der metallenen Deckel 16 durch die Bohrung 38 des Stutzens 37.

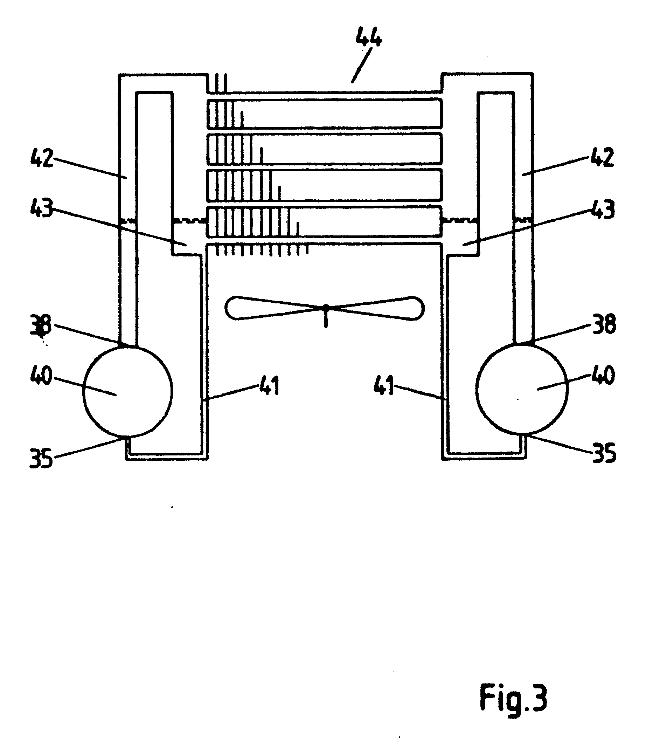

In Fig. 3 ist eine Gesamtanordnung von zwei Leistungshalbleiterbauelementen 40 mit Rückkühleinrichtung dargestellt. Jeder der beiden Leistungshalbleiterbauelemente 40 (es können beliebig viele weitere derartige Elemente vorhanden sein) besitzt im unteren Teil an der Bohrung 35 eine Kältemittelzulaufleitung 41 für den Zulauf des flüssigen Kältemittels und im oberen Teil an der Bohrung 38 eine Kältemittelablaufleitung 42 für den Ablauf des durch die in der Halbleiterkristallscheibe 1 erzeugten Verlustwärme aufgeheizten, gasförmigen Kältemittels. Die Kältemittelzulaufleitungen 41 sind dabei geringer dimensioniert als die Kältemittelablaufleitungen 42. Zur Kühlung des Kältemittels 43 ist ein Rückkühler 44 vorgesehen. Der Kühler 44 besteht im wesentlichen aus verrippten Rohren, wobei die Rohre mit der Kühlluft eines Ventilators angeblasen werden. Der Kühler 44 gibt die in den Bauelementen 40 angefallene Wärme über Kondensation an die Umgebung ab. Der Rückkühler 44 muss räumlich höher als die einzelnen Leistungshalbleiterbauelementen 40 angeordnet sein, um einen einwandfreien Zulauf des flüssigen Kältmittels 43 zu den Bauelementen 40 ohne zusätzliche Pumpe zu gewährleisten.

Als Kältemittel mit ausgezeichneten Eigenschaften eignet sich ein Kältemittel Typ 113 ($C_2F_3Cl_3$) mit einem Siedepunkt von 47,6 °C bei Normaldruck. Es besitzt eine grosse elektrische Durchschlagfähigkeit von etwa 15kV/mm sowohl im flüssigem wie im gasförmigen Zustand und ist nicht brennbar und nicht toxisch. Die Wärmeübergangszahl, eine kennzeichnende Grösse einer Kühlungsart, ist ausgezeichnet und liegt bei der von strömendem Wasser. Aber auch sogenannte inerte Flüssigkeiten, die den Vorteil der praktisch absoluten materialverträglichkeit aufweisen, sind als Kältemittel einsetzbar, sie sind allerdings sehr teuer.

**Patentansprüche**

1. Leistungshalbleiterbauelement für Siedekühlung mit einer zwei Hauptelektroden und gegebenenfalls eine oder mehrere Steuerelektroden aufweisenden Halbleiterkristallscheibe, die in einem von einem elektrisch isolierenden Kältemittel durchströmbaren flüssigkeits- und gasdichten Gehäuse eingebaut ist, wobei die beiden Hauptelektroden der Halbleiterscheibe zur weitestgehenden thermischen und mechanischen Entlastung elektrisch mit Multikontakten verbunden sind und das Gehäuse im wesentlichen aus einer Keramikhülse mit beidseitig aufgesetzten metallenen Deckeln besteht sowie Kältemittelanschlüsse besitzt, dadurch gekennzeichnet, dass die Multikontakte (2) mit im Gehäuseinneren integrierten Kühlkörpern (10) stoffschlüssig elektrisch und thermisch kontaktierbar sind, wobei die Kühlkörper (10) aus dem Gehäuse ragende Anschlussaugen (13) zum elektrischen Anschluss der Hauptelektroden besitzen, dass das Gehäuse mit einer Isolierhülse (30) umpresst ist, wobei die Isolierhülse (30) mindestens einen Stutzen (37) mit einer Bohrung (38) für den Kältemittelanschluss aufweist und am Ort des Kältemittelanschlusses die metallenen Deckel (16) teilkreisförmige Ausschnitte (24) sowie die Keramikhülse (20) eine Bohrung (25) aufweisen und dass der Siederaum durch den von der Keramikhülse (20) gebildeten Innenraum gebildet wird.

2. Leistungshalbleiterbauelement nach Anspruch 1, dadurch gekennzeichnet, dass zwischen Keramikhülse (20) und metallenen Deckeln (16) eine Spalte (27) für den Kältemittelzulauf gebildet wird.

3. Leistungshalbleiterbauelement nach einem der vorstehenden Ansprüche, dadurch gekennzeichnet, dass die Isolierhülse (30) zwei Stutzen (34, 37) mit zwei Bohrungen (35, 38) für den getrennten Kältemittelzu- und -ablauf und die metallenen Deckel (16) entsprechende teilkreisförmige Ausschnitte (24) sowie die Keramikhülse (20) entsprechende Bohrungen (25) aufweisen.

4. Leistungshalbleiterbauelement nach einem der vorstehenden Ansprüche, dadurch gekennzeichnet, dass die Keramikhülse (20) am Ort des Kühlmittelanschlusses eine Abflachung (23) aufweist.

5. Leistungshalbleiterbauelement nach einem der vorstehenden Ansprüche, dadurch gekennzeichnet, dass Noppen (33) an der Innenseite der Isolierhülse (30) vorgesehen sind, die durch Bohrungen (18) in den metallenen Deckeln (16) in Grundbohrungen (22) der Keramikhülse (20) eingreifen.

6. Leistungshalbleiterbauelement nach einem der vorstehenden Ansprüche, dadurch gekennzeichnet, dass die metallenen Deckeln (16) Bohrungen (17) aufweisen, die auf Andrehungen (15) der Anschlussaugen (13) schiebbar sind.

7. Leistungshalbleiterbauelement nach einem der vorstehenden Ansprüche, dadurch gekennzeichnet, dass die Kühlkörper (10) einen Boden (11) und an diesen angeformte Kühlzapfen (12) aufweist.

8. Leistungshalbleiterbauelement nach einem der vorstehenden Ansprüche, dadurch gekennzeichnet, dass die Isolierhülse (30) beidseitig mit Isolierdeckeln (32) versehen ist.

9. Leistungshalbleiterbauelement nach einem der vorstehenden Ansprüche, dadurch gekennzeichnet, dass ein Steueranschluss auf der Halbleiterkristallscheibe (1) über eine Bohrung (3) im Multikontakt (2) und eine interne Gate-Anschlussleitung (4) erfolgt, die andererseits mit einem Anschlussstift (5) verbunden ist, der über eine Bohrung (26) in der Keramikhülse (20), eine Bohrung (18) im metallenen Deckel (16) und eine Büchse (6) in der Isolierhülse (30) das Gehäuse durchstösst.

**Claims**

1. Power semi-conductor component for boiling-water cooling, comprising a semi-conductor crystal disc having two main electrodes and possibly one or more control electrodes and which is installed in a liquid- and gas-tight housing through which an electrically insulating coolant can flow, the two main electrodes of the semi-conductor disc being electrically connected to multi-contacts to provide best-possible thermal and mechanical relief and the housing essentially consisting of a ceramic shell with metal covers placed on it on both sides and having coolant connections, characterised in that the multi-contacts (2) can be surface-contacted electrically and thermally with heat sinks (10) integrated in the interior of the housing, the heat sinks (10) having connecting eyes (13) projecting from the housing for the electrical connecting of the main electrodes, that an insulating shell (30) is pressed around the housing, the insulating shell (30) having at least one stub (37) with a hole (38) for the coolant connection and the metal covers (16) having sector-shaped cutouts (24) and the ceramic shell (20) having a hole (25) at the location of the coolant connection, and that the boiling space is formed by the internal space formed by the ceramic shell (20).

2. Power semi-conductor component according to Claim 1, characterised in that a gap (27) for the coolant ingress is formed between ceramic shell (20) and metal covers (16).

3. Power semi-conductor component according to one of the preceding claims, characterised in that the insulating shell (30) has two stubs (34, 37) having two holes (35, 38) for separate coolant ingress and egress and the metal covers (16) have corresponding sector-shaped cutouts (24) and the ceramic shell (20) has corresponding holes (25).

4. Power semi-conductor component according to one of the preceding claims, characterised in that the ceramic shell (20) has a flattened area (23) at the location of the coolant connection.

5. Power semi-conductor component according to one of the preceding claims, characterised in that knobs (33) are provided on the inside of the insulating shell (30) which engage blind holes (22) of the ceramic shell (20) through holes (18) in the metal covers (16).

6. Power semi-conductor component according to one of the preceding claims, characterised in that the metal covers (16) have holes (17) which can be pushed onto nicks (15) on the connecting eyes (13).

7. Power semi-conductor component according to one of the preceding claims, characterised in that the heat sinks (10) have a bottom (11) and cooling studs (12) formed of one piece therewith.

8. Power semi-conductor component according to one of the preceding claims, characterised in that the insulating shell (30) is provided with insulating covers (32) on both sides.

9. Power semi-conductor component according to one of the preceding claims, characterised in that a control connection on the semi-conductor crystal disc (1) is made via a hole (3) in the multicontact (2) and an internal gate connecting line (4) which, on the other hand, is connected to a connecting pin (5) which penetrates through the housing via a hole (26) in the ceramic shell (20), a hole (18) in the metal cover (16) and a bush (6) in the insulating shell (30).

**Revendications**

1. Composant semiconducteur de puissance à refroidissement par vaporisation, comportant une plaque de semiconducteur cristallin qui présente deux électrodes principales et éventuellement une ou plusieurs électrodes de commande et qui est montée dans un boîtier étanche aux liquides et aux gaz, apte à être parcouru par un réfrigérant électriquement isolant, les deux électrodes principales de la plaque de semiconducteur étant électriquement connectées au moyen de contacts multiples afin de réduire très fortement leur sollicitation thermique et mécanique, et le boîtier étant constitué, pour l'essentiel, par un manchon en céramique avec des couvercles métalliques disposés des deux côtés, ce boîtier possédant en outre des raccords de réfrigérant, caractérisé par le fait que les contacts multiples (2) peuvent être mis en contact, thermiquement et électriquement, par une liaison par matière, avec des refroidisseurs intégrés dans l'intérieur du boîtier, ces refroidisseurs (10) possédant des embouts de raccordement (13) qui débordent hors du boîtier, pour le raccordement électrique des électrodes principales, par le fait que le boîtier est surmoulé par un manchon isolant (30) qui présente au moins une tubulure (37) dotée d'un trou (38) pour le raccord de réfrigérant, à l'endroit duquel les couvercles métalliques (16) présentent des découpures (24) en forme de portion de cercle et le manchon en céramique (20) présente un trou (25), et par le fait que la chambre de vaporisation est formée par l'espace intérieur constitué par le manchon en céramique (20).

2. Composant semiconducteur de puissance selon revendication 1, caractérisé par le fait qu'un interstice (27) pour l'admission du réfrigérant est formé entre manchon en céramique (20) et couvercles métalliques (16).

3. Composant semiconducteur de puissance selon l'une quelconque des revendications précédentes, caractérisé par le fait que le manchon isolant (30) présente deux tubulures (34, 37) avec deux trous (35, 38) pour l'admission et l'évacuation séparées du réfrigérant, et les couvercles métalliques (16) présentent des découpures correspondantes (24) en forme de portion de cercle, le manchon en céramique (20) présentant des trous correspondants (25).

4. Composant semiconducteur de puissance selon l'une quelconque des revendications précédentes, caractérisé par le fait que le manchon en céramique (20) présente un plat (23) à l'endroit du raccord pour réfrigérant.

5. Composant semiconducteur de puissance selon l'une quelconque des revendications précédentes, caractérisé par le fait que des tétons (33) sont prévus sur le côté intérieur du manchon isolant (30) et s'engagent dans des trous borgnes (22) du manchon en céramique (20) en traversant des trous (18) dans les couvercles métalliques (16).

6. Composant semiconducteur de puissance selon l'une quelconque des revendications précédentes, caractérisé par le fait que les couvercles métalliques (16) présentent des trous (17) pour leur emboîtement sur des parties d'extrémité (15) de section réduite des embouts de connexion (13).

7. Composant semiconducteur de puissance selon l'une quelconque des revendications précédentes, caractérisé par le fait que les éléments de refroidissement (10) présentent un fond (11) et des saillants de refroidissement (12) formés sur celui-ci.

8. Composant semiconducteur de puissance selon l'une quelconque des revendications précédentes, caractérisé par le fait que le manchon isolant (30) est muni, des deux côtés, de couvercles isolants (32).

9. Composant semiconducteur de puissance selon l'une quelconque des revendications précédentes, caractérisé par le fait qu'une connexion de commande allant à la plaque de semiconducteur cristallin (1) est réalisée au moyen d'un trou (3) dans le contact multiple (2) et d'un conducteur interne de gâchette (4), lequel est relié, de l'autre côté, à une broche de raccordement (5), laquelle traverse le boîtier en passant par un trou (26) dans le manchon en céramique (20), un trou (18) dans le couvercle métallique (16) et une bague (6) dans le manchon isolant (30).

Fig.1

**Fig.2**

Fig.3